# EUROPEAN PATENT APPLICATION

(11) **EP 3 740 053 A1**
(43) Date of publication of application: **18.11.2020**
(21) Application number: 19174271.7
(22) Date of filing: 14.05.2019
(51) Int. Cl.: H05K 7/20

(54) **COOLING SOLUTION FOR INVERTER CABINET WITH SEVERAL COMPARTMENTS**

(71) Applicant: ABB Schweiz AG, 5400 Baden (CH)
(72) Inventor: Jauhonen, Roman, 00380 Helsinki (FI); Keränen, Ilmari, 00380 Helsinki (FI); Roos, Emma, 00380 Helsinki (FI)
(74) Representative: Kolster Oy Ab

(57) **Abstract**

The invention relates to an electrical apparatus such as an inverter or other electrical apparatus. Apparatus comprises a cabinet (C) having multiple cabinet sections (C1-C4), each cabinet section (C1-C4) enclosing cabinet-specific electrical arrangement (M1-M4). Apparatus further comprises cooling arrangement (AI1, FA1, A01) for cooling, said cooling arrangement comprising at least one air intake (AI1) for external air, at least one primary element (FI1) for filtering the incoming air, at least one fan (FA1) and at least one air outlet, wherein the fan (FA1) is arranged cause airflow towards the air outlet (A01). The cooling arrangement comprises a cooling air flowpath (FP21) from a first cabinet section (C1) to a second cabinet section (C2), and a secondary element (F12) for filtering the cooling air entering the second cabinet section (C2), and an additional fan (FA2) for creating cooling air airflow into and out from the second cabinet section (C2).

## Description

### FIELD OF THE INVENTION

The present invention relates to electrical apparatus, such as inverter or other electrical apparatus. One possible use for such an electrical apparatus is outdoors installed inverter that is connected between group of solar panels and an electrical grid (electrical distribution network).

### BACKGROUND

Electrical apparatus such as inverter comprises multi-sectioned cabinet, each section of the cabinet containing section-specific electrical arrangements (components), such as circuit specific protection or switching components (contactors, fuses, breakers) or modules of an inverter which contain plurality of switching, controlling and power supply related components, for example.

As a side-effect, electrical components of the electrical apparatus create excess heat which causes a risk of overheating within the cabinet. Therefore, there is a need for cooling the internal space of the cabinet, in order to eliminate any risk of fire or any risk that the components of the electrical arrangements would be damaged due to excess heat.

In previously known electrical apparatuses, the cooling arrangement comprises basic elements such as air intake with a filter, air outlet and a fan therebetween. Air intake and air outlet are at the circumference of the cabinet, the fan is within the cabinet.

Regarding the cooling of the cabinet, the abovementioned basic setting is not optimal, especially if at least one of the cabinet sections contain especially sensitive components in the electrical arrangement.

### BRIEF DESCRIPTION OF THE INVENTION

Therefore, an object of the present invention is to provide an apparatus so as to solve or at least to alleviate the above disadvantages. The objects of the invention are achieved by an apparatus, which is characterized by what is stated in the independent claim. The preferred embodiments of the invention are disclosed in the dependent claims.

The invention is based on cooling arrangement that is modified according to electrical arrangements enclosed by each cabinet section.

The apparatus provides advantages. The electrical apparatus is equipped with suitable cooling arrangement according to the needs specified by the electrical arrangements (components) being enclosed in different cabinet sections of the cabinet of the electrical apparatus.

### BRIEF DESCRIPTION OF THE DRAWINGS

In the following the apparatus will be described in greater detail by means of preferred embodiments with reference to the attached drawings, in which:
Figure 1 shows a front side perspective view of an inverter apparatus.
Figure 2 shows a back side perspective view of an inverter apparatus.
Figure 3 is a simplified top view of an inverter apparatus.
Figure 4 is a simplified view of the DC connection section and the control section.
Figure 5 is a simplified view of the power section.
Figure 6 is a simplified view of the AC section.
Figure 7 show magnetically secured hatch arrangement for the outlet.

### DETAILED DESCRIPTION OF THE INVENTION

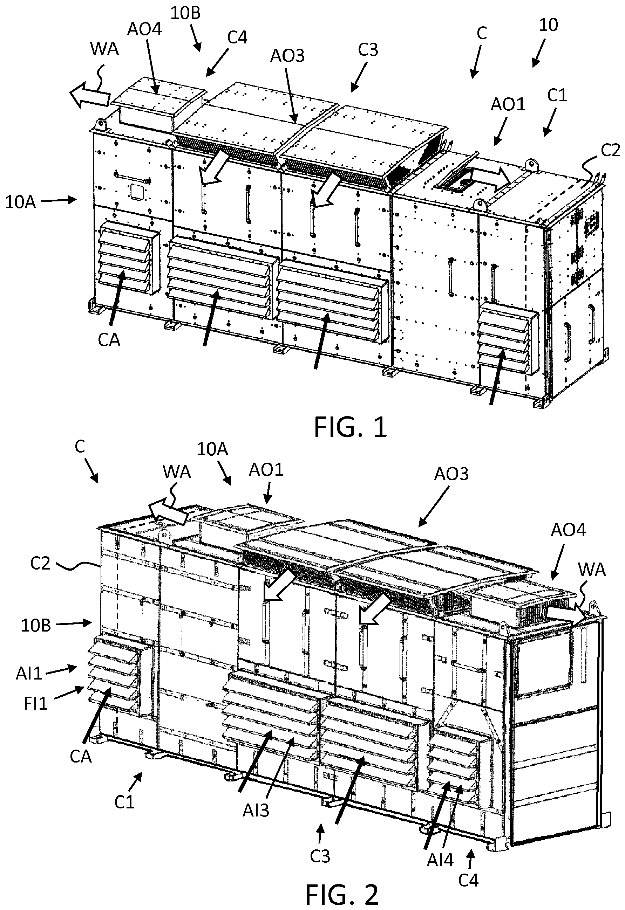

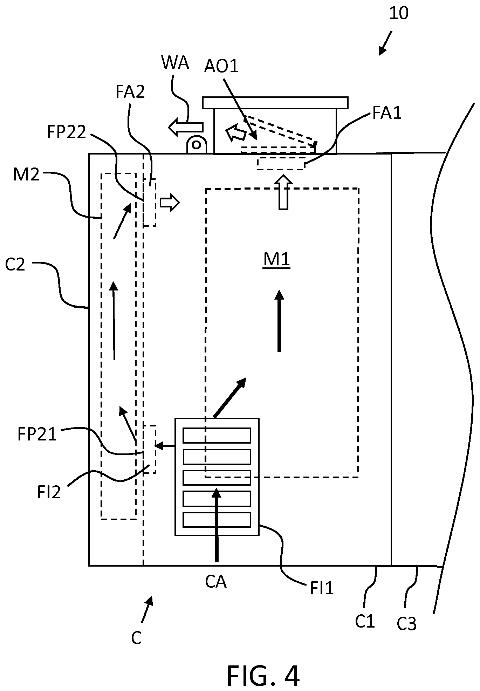

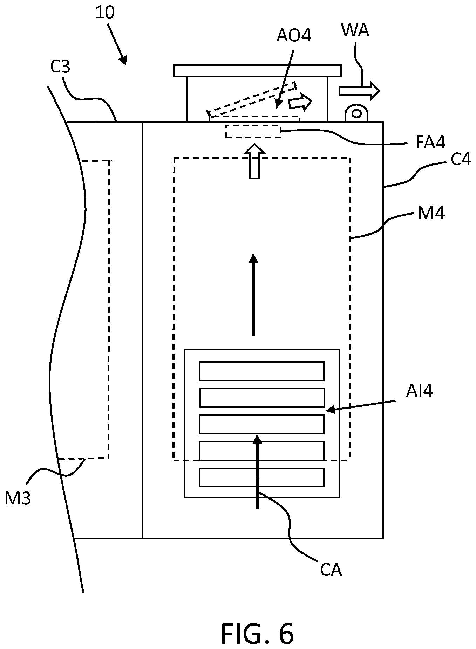

Referring to Figures 1-6, especially to figures 1-2, the invention relates to an electric apparatus 10. In an embodiment the apparatus is an inverter for outdoors (open air) use and it is connected to electrical grid. One possible use for the inverter 10 is for inverting the DC voltage output of solar (photovoltaic) panels to AC voltage for the electrical grid. As an example only, the capacity of the inverter can be for example in the range of 1-10MVA, preferably 3-6 MVA, and having DC input voltage up to 1500 V and three phase AC voltage of 600-800Vac,rms between phases. Referring especially to figures 1-3, the inverter 10 can be a dual type inverter having "back to back"-structure having two inverter sections 10A, 10B, wherein each inverter section 10A, 10B can comprise plurality of electrically parallel connected inverter power module sections M31-M32 and M33-M34 within power arrangement (power module) M3 enclosed in cabinet section C3. Some of the electrical components located in cabinet sections C1, C2 and C4 are common for all the inverter power module sections M31-M34 of the power arrangement M3.

Below, the description of the apparatus is mainly relating for the inverter section 10B which is at the back side of the apparatus, shown in figure 2. The inverter section 10A, which is at the front side of the apparatus, is shown in figure 1.

The electrical apparatus 10 comprises a cabinet C having multiple cabinet sections C1-C4, each cabinet section enclosing cabinet-specific electrical arrangement M1-M4.

In an embodiment, the first cabinet section C1 is a DC connection section of an Inverter, said DC-connection section enclosing DC-arrangement as a section-specific electrical arrangement. Common for all inverter modules M31-M34, the DC arrangement M1 contains (not shown) inlets for input cables of PV-panels (Photovoltaic), connecting terminals for those input cables and also safety devices such as DC input fuses, DC surge protectors, measurement devices and EMC-filters, and DC busbar branches to which the cables from PV panels are connected, said DC busbar having also a primary busbar leading from section C1 to C3 and further to inverter modules M31-M34.

In an embodiment, the second cabinet section C2 is a control section of an Inverter, said control-section enclosing a control arrangement C2 as a section-specific electrical arrangement. Control arrangement M2 of cabinet section C2 contains (not specifically shown) auxiliary electrical devices, such as control electronics, power source, buffers and protective devices. Those auxiliary electrical devices are arranged to serve the whole inverter 10.

Regarding the third functional arrangement M3, enclosed by cabinet section C3, in an embodiment third cabinet section C3 is a power section of an Inverter, said power section of the cabinet enclosing a power arrangement (module) M3 as a section-specific electrical arrangement. Cabinet section C3 of functional arrangement M3 encloses four electrically parallel connected inverter power module sections M31-M34, each of the inverter power module sections comprises (not specifically shown) DC switching components, DC fuses, common mode filters (EMC), inverter power modules PM (shown) and LCL-filters LCL (shown), DC capasitors, PCBs (Printed Circuit Boards) and busbars.

Furthermore, again regarding the fourth functional arrangement, in an embodiment the fourth cabinet section C4 is a AC section of an Inverter 10, said AC section enclosing an AC arrangement M4 as a section-specific electrical arrangement.AC arrangement M4 contains (not specifically shown) components such as auxiliary transformer, AC contactor, AC breaker, AC output busbars, AC overvoltage protecting device and also charging circuitry (resistors, contactors). AC breaker and AC output busbars are common for the whole inverter. AC busbars (not shown) from inverter module branches are combined at section C4, the AC busbars are leading towards the AC connection terminals at the end of cabinet section C4.

In this context, the third cabinet section C3 is considered to be cabinet section for the power arrangement (power module) M3, and fourth cabinet section C4 is considered to be cabinet section for the AC arrangement M4.

In this text first, second, third and fourth (and numbers 1, 2, 3, 4) do not necessarily relate to but they can relate to certain order as to how sections and therein enclosed electrical functional arrangements M1-M4 are in relation to other sections. Use of first etc. is mainly for differentiating structures from other more or less corresponding structures. However, the above mentioned use of first etc. is done in a manner trying to correspond to the layout out the apparatus 10, starting from a DC connection cabinet section C1 (first) enclosing the DC arrangement M1 and ending to AC output cabinet section C4 (fourth) enclosing the AC arrangement M4.

Apparatus further comprises cooling arrangement for cooling, said cooling arrangement comprising at least one air intake AI1 for external air, at least one primary element FI1 for filtering the incoming air, at least one fan FA1 and at least one air outlet AO1, wherein the fan is arranged to cause airflow towards the air outlet A01. The above mentioned refers especially to cabinet section C1 having electric arrangement M1, but also the other cabinet sections C3, C4 have cooling sub-arrangements such as air intake for external air, primary element/filter for filtering the incoming air and also a fan that is arranged to cause airflow towards the air outlet of the related cabinet section. Weather protection hood (as shown), or alternatively a sandtrap filter, can be in front of the primary filter element.

Regarding air outlet AO1, in figure 1 the air outlet AO1 is shown without the cover that is shown in figure 2 on top of air outlet AO1.

In the figures, arrows CA relate to cold air / cooling air, and arrows WA relate to warm air that is exhausted from the cabinet sections.

Regarding cabinet section C2 which is the cabinet section for the control section arrangement M2, the structure is a bit different as will discussed later below, because the air inlet for the cabinet section C2 is not for the external (from open air) air but for air from the cabinet section C1, and because the air outlet for cabinet section C2 may need not necessarily be directly to actual air outlet A01, but instead or alternatively the air outlet from cabinet section C2 can be opening to cabinet section C1 which is the cabinet section enclosing DC arrangement M1, and from thereon (from cabinet section C1) the air is drawn, using fan FA1, to the open air via actual outlet AO1 at the circumference of the cabinet section C1, in an embodiment the outlet AO1 is at the cabinet top CT.

Therefore, cooling arrangement comprises a cooling air flowpath FP21 from a first cabinet section C1 to the second cabinet section C2, and a secondary element FI2 for filtering the cooling air entering the second cabinet section C2. Additionally, the cooling arrangement comprises an additional fan FA2 for creating cooling air airflow into and out from the second cabinet section C2. Air flowpath FP21 is the air inlet for the cabinet section C2, but not directly from open air but from inside area of cabinet section C1.

In this this way the cooling air to cabinet C2 comes, not directly from open air, but from the cabinet section C1, and the cooling air for cabinet section C2 is filtered in two phases: in first phase with primary filter element FI1 that is arranged for filtering the air from outside (open air) and later in second phase with filter FI2 that is arranged for filtering the air entering the cabinet section C2 from cabinet section C1 through flowpath FP21.

The cooling arrangement further comprises a cooling air flowpath FP22, from a second cabinet section C2 preferably back to the first cabinet section C1, in an embodiment. Flowpath FP22 is the outlet of cabinet section C2, for letting air away/out from cabinet section C2, but not directly to open air but first to cabinet section C2 and then to outside air via Air outlet AO1, air being drawn by fan FA1 of the cabinet section C1.

Regarding the location of the above mentioned air flowpaths FP21, FP22, in an embodiment the cooling air flowpath FP21 from a first cabinet section C1 to a second cabinet section CA and/or cooling air flowpath from a second cabinet section back to the first cabinet section are at an intermediate wall W between the first cabinet section C1 and the second cabinet section C2.

As can be seen from figures 1-4, in an embodiment the second cabinet section C2 is within the first cabinet section C1.

Regarding some aspects of cooling, in an embodiment the cooling arrangement comprises section-specific sub-arrangement for cooling of each cabinet section, each cabinet section enclosing section- specific electrical arrangement.

Referring to above, for cabinet section C1 (for DC arrangement M1) the first sub-arrangement comprises air inlet AI1, filter FI1, fan FA1, air outlet AO1.

For cooling of cabinet section C2 (for control section arrangement M2) the second sub-arrangement comprises filter FI1, flowpath (air inlet) FP21, flowpath (air outlet) FP22. And because the cooling of cabinet section C2 is related to cooling of cabinet section C1 (for DC arrangement M1), it can be considered that also in air inlet AI1 and air outlet AO1 of cabinet C1 belong to or at least cooperate with the second sub-arrangement for cooling.

For cooling of cabinet section C3 (for power arrangement M3) the third sub-arrangement comprises air inlet AI3, filter FI3, fan FA3, air outlet AO3.

For cooling of cabinet section C4 (for AC arrangement M4) the third sub-arrangement comprises air inlet AI4, filter FI4, fan FA4, air outlet AO4.

In an embodiment, the section specific sub-arrangement for cooling a cabinet section comprises one or more a fan having a different assembly-height within the cabinet section and/or different amount of air output, compared to one or more fan of another cabinet section. For example, fan FA1 of cabinet section C1 (for DC-arrangement M1), fan FA2 of cabinet section C2 (for control section arrangement M2) and fan FA32 (for power section M3) are all in different assembly-height locations. Furthermore, for example, the air output of fan FA2 of cabinet section C2 and air output of fan FA32 of cabinet section C3 are lower than the air output of fan FA1 of cabinet section C1 and fan FA4 of cabinet section C4.

Regarding the fans, the air volume of the larger fans like FA1, FA3, FA4 on top area of the cabinet C is, in an embodiment, around 1000 m3/h (cubic meter / hour). The air volume of smaller fans like FA2, FA32 is, in an embodiment, around 300 m3/h.

In an embodiment, regarding the amount of larger fans on top of the cabinet C, for DC arrangement M1 enclosed in cabinet section C1, there are two fans like fan FA1. For power arrangement (power module) M3 enclosed in cabinet section M3, there are twenty two fans, like fan FA3.

In an embodiment, regarding the amount of smaller fans, for control arrangement C2 enclosed in cabinet section C2, there is one fan like fan FA2. Regarding cabinet section C3, for the power arrangement M3 having power modules M31-M32, there are three fans like FA32 for each of the power modules M31-M34, therefore total amount of smaller fans can be thirteen.

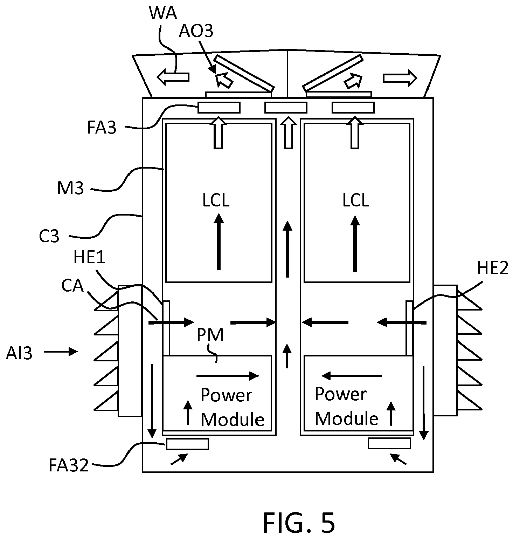

Referring especially to figure 5, the sub-arrangement for cooling the power section comprises a fan at a low assembly height in order to draw part of the incoming air from the air input to the lower part of that cabinet section, and the sub-arrangement for cooling the power section further comprises a fan at a high assembly height for drawing the air out via the air outlet. Fan FA32 is at bottom of the cabinet section C3, fan FA2 is at the top of the cabinet section C3, and in any case fan FA32 is at lower height-position (assembly-height) compared to fan FA3. Also, the air output of fan FA32 is lower than the primary fan FA3 of the same cabinet section C3. Referring to above, in an embodiment, fan FA32 at the low assembly height has less air output than the fan FA3 at the high assembly height in same cabinet section C3. The airflow provided by the fan FA32 is especially directed to cool the electronic boards and DC-link capacitor of a inverter power module PM, whereas the substantial airflow provided by the fan FA3 cools the semiconductor components (IGBTs i.e Insulated Gate Bipolar Transistors, GaN i.e Gallium Nitride, SiC i.e Silicon Carbide) of the inverter power module via base-to-air heat exchanger HE1, HE2 in figure 5, such as a two phase thermosyphon arrangement described in document US9897383. As the cooling air provided by the fans FA3 is drawn from the air inlet AI3, the cooling air after filtering goes through the heat exchanger of the inverter power module and continues to cool other electrical components of the cabinet section as it flows through the cabinet towards air outlet AO3. By directing the airflow is such way, the inverter power modules (having high power loss) are efficiently cooled with fresh (cool) outside air, and the other components (LCL components, contactors, fuses etc.) dissipating less loss power can also be sufficiently cooled.

Similarly, air output of fan FA2 (for cabinet section C2) that draws air from cabinet section C2 back to cabinet section C1, is lower than the primary fan FA1 of the cabinet section C1. In an embodiment, about 15 % of the air entering the first cabinet section C1 is drawn to cool the second cabinet section C2.

In an embodiment, the air inlets AI1, AI3 and AI4 are at the side surface, preferably at the vertical side surface of the cabinet C. Also in an embodiment, the air outlets AO1, AO3, AO4 are at the top surface CT of the cabinet C.

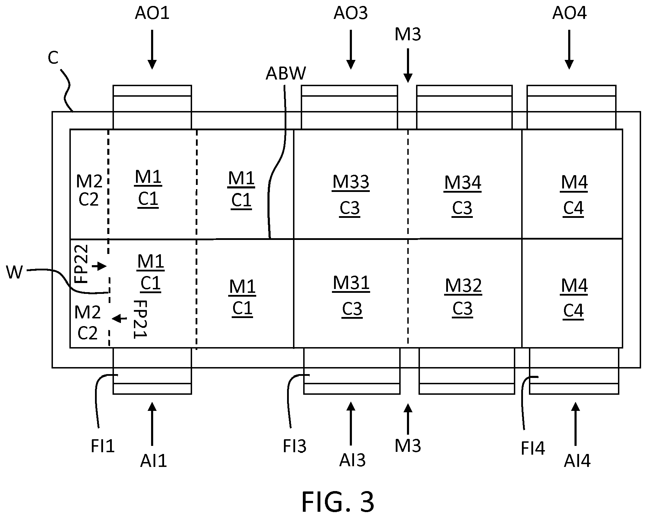

Referring to figure 3, there is shown the air barrier wall ABW separating the inverter sections 10A and 10B, so as not to let the incoming (via air inlets) cooling air to flow out from the cabinet (via the air inlets of the other
inverter section). The air barrier wall also prevents wind from blowing through the inverter cabinet C.

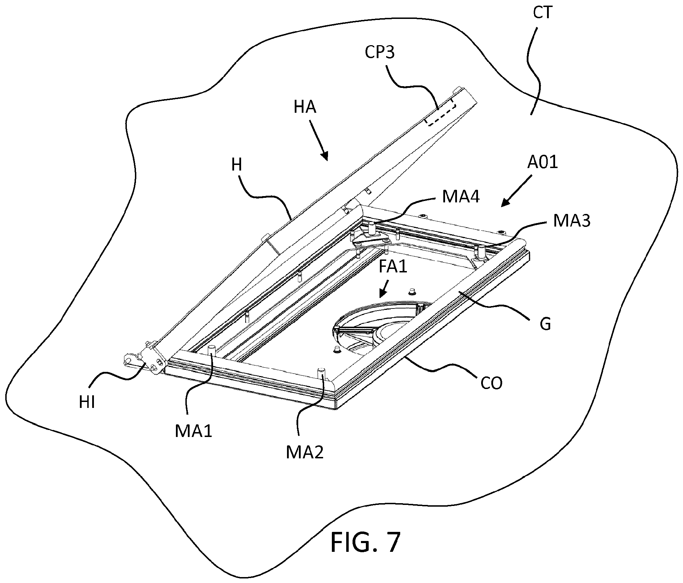

Referring especially to figure 7, and to figures 1-2 and 4, 1-2, in an embodiment, one or more air outlet, such as outlet AO1 comprises a hatch arrangement HA that comprises a hatch H and a magnetic securing arrangement for keeping the hatch H in a closed position. The hatch arrangement HA also comprises a hinge HI, collar/frame CO and gasket GA such as polymer gasket.

In an embodiment, magnetic securing arrangement comprises magnets MA1-MA4. If hatch H is not of magnetic material (magnetic metal) then the hatch H comprises magnetic (for example magnetic metal) counterparts for magnets, like counterpart CP3 for the magnet MA3. In figure 7, CT refers to cabinet top that defines/comprises the air outlet AO1.

In a hot enough situation within the cabinet C, the control of the fans is adjusted in relation to the magnetic securing force of the hatch in such way that with strong enough air flow, the magnetic force is not anymore able to keep the hatch closed.

It will be obvious to a person skilled in the art that, as the technology advances, the inventive concept can be implemented in various ways. The invention and its embodiments are not limited to the examples described above but may vary within the scope of the claims.

## Claims

1. Electrical apparatus such as an inverter or other electrical apparatus, said apparatus comprising a cabinet (C) having multiple cabinet sections (C1-C4), each cabinet section (C1-C4) enclosing cabinet-specific electrical arrangement (M1-M4), and wherein said apparatus further comprises cooling arrangement (AI1, FA1, AO1) for cooling, said cooling arrangement comprising at least one air intake (AI1) for external air, at least one primary element (FI1) for filtering the incoming air, at least one fan (FA1) and at least one air outlet, wherein the fan (FA1) is arranged cause airflow towards the air outlet (AO1),
**characterized in that** the cooling arrangement comprises
- a cooling air flowpath (FP21) from a first cabinet section (C1) to a second cabinet section (C2), and
- a secondary element (FI2) for filtering the cooling air entering the second cabinet section (C2), and
- an additional fan (FA2) for creating cooling air airflow into and out from the second cabinet section (C2).

2. The apparatus according to claim 1, **characterized in that** the cooling arrangement further comprises a cooling air flowpath (FP22) from the second cabinet section (C2) back to the first cabinet section (C1).

3. The apparatus according to claim 1 or 2, **characterized in that** the cooling air flowpath (FP21) from a first cabinet (C1) section to a second cabinet section (C2) and/or cooling air flowpath from a second cabinet section (C2) back to the first cabinet (C1) section are at an intermediate wall (W) between the first cabinet section (C1) and the second cabinet section C2).

4. The apparatus according to any of claims 1-3, **characterized in that** the second cabinet section (C2) is within the first cabinet section (C1).

5. The apparatus according to any of claims 1-4, **characterized in that** the cabinet (C) of the apparatus further comprises a third cabinet section (C3).

6. The apparatus according to claim 5, **characterized in that** the cabinet (C) of the apparatus further comprises a fourth cabinet section (C4).

7. The apparatus according to any of claims 1-6, **characterized in that** the cooling arrangement comprises section-specific sub-arrangement (AI3, FI3, FA3, AO3) for cooling of each cabinet section, each cabinet section enclosing section specific-electrical arrangement.

8. The apparatus according to claim 7, **characterized in that** section-specific sub-arrangement for cooling a cabinet section comprises one or more a fan (FA32) having a different assembly-height within the cabinet section (C3) and/or different amount of air output, compared to one or more fan (FA1, FA2, FA4) of another cabinet section (C1, C2, C4).

9. The apparatus according to any of claims 1-8, **characterized in that** the first cabinet section (C1) is a DC connection section of an Inverter, said DC-connection section enclosing DC-arrangement (M1) as a section-specific electrical arrangement.

10. The apparatus according to any of claims 1-9, **characterized in that** the second cabinet section (C2) is a control section of an Inverter, said control-section enclosing a control arrangement (M2) as a section-specific electrical arrangement.

11. The apparatus according to claim 5 or 6, **characterized in that** the third or fourth cabinet section is a power section (C3) of an Inverter, said power section enclosing a power arrangement (M3, M31-M34) as a section-specific electrical arrangement.

12. The apparatus according to claim 5 or 6, **characterized in that** the third or fourth cabinet section is a AC section (C4) of an Inverter, said AC section enclosing an AC arrangement (M4) as a section-specific electrical arrangement.

13. The apparatus according to claim 7 and 11, **characterized in that** the that sub-arrangement for cooling the power section (C3) of the cabinet (C) comprises a fan (FA32) at a low assembly height in order to draw part of the incoming air from the air input (AI3) to the lower part of that cabinet section (C3), and the sub-arrangement for cooling the power section (C3) of the cabinet (C) further comprises a fan (FA3) at a high assembly height for drawing the air out via the air outlet (AO3).

14. The apparatus according to claim 13, **characterized in that** the fan (FA32) at the low assembly height has less air output than the fan (FA3) at the high assembly height.

15. The apparatus according claim 1, **characterized in that** one or more air outlet comprises a hatch arrangement (HA), that comprises a hatch (H) and a magnetic securing arrangement (M1-M4) for keeping the hatch in a closed position.
